# EUROPEAN PATENT SPECIFICATION

(11) **EP 2 864 695 B1**
(45) Date of publication and mention of the grant of the patent: **27.04.2016**
(21) Application number: 13741811.7
(22) Date of filing: 17.06.2013
(51) Int. Cl.: F21S 9/04, H01L 35/32

(54) **ENERGY RECOVERY APPARATUS**
ENERGIERÜCKGEWINNUNGSVORRICHTUNG
APPAREIL DE RÉCUPÉRATION D'ÉNERGIE

(30) Priority: 22.06.2012 GB 201211068
(43) Date of publication of application: 29.04.2015
(73) Proprietor: Elsarrag, Esam, Doha (QA); Al-Horr, Yousef, Doha (QA)
(72) Inventor: Elsarrag, Esam, Doha (QA); Al-Horr, Yousef, Doha (QA)
(74) Representative: Gaunt, Thomas Derrick
(86) International application number: PCT/GB2013/051566
(87) International publication number: WO 2013/190271

(56) References cited:
- WO-A1-99/16136
- JP-A- 2007 094 037
- US-A1- 2005 000 559
- US-A1- 2010 207 573

## Description

The present invention relates to energy recovery apparatus for use with lighting systems.

Lighting systems of one form or another are incorporated into many surroundings in people's lives. These lighting systems require energy to operate. When the lighting systems receive energy they generate light, but also heat as by-product. Such heat can be useful in certain limited applications, such as when particular lamps are used for keeping food warm, but for the most part such heat energy is lost and thereby wasted.

JP 2007 094037 A discloses a projector arrangement where the temperature between the air inlet and the air outlet is transferred through heat pipes to a thermoelectric module for generating electricity. This electricity is used for powering cooling fans for cooling the projector's lamp after the unit has been turned off.

The present invention is directed towards recovering and harvesting the heat energy lost in lighting systems.

According to an aspect of the present invention there is provided apparatus for collecting energy within a powered lighting system, said apparatus comprising:-
a light source;
a heat exchanger;
characterised in that the apparatus further comprises a thermoelectric element disposed between the light source and the heat exchanger, and being at or adjacent to the light source for recovering heat energy produced by the light source to generate electricity; and
air flow channels provided between the light source and the thermoelectric element for guiding air flow around the light source for recovering heat energy produced by the light source.

In this connection, such apparatus allows recovery of heat energy which would otherwise have been wasted.

Such recovered heat energy can be used as one or more of a source of power, a source of heating, a means for heating water, a means for cooling, a means for dehumidification, a means for desalination or a means for desiccation.

Preferably, the thermoelectric element is a thin film element, a thick film element or an organic element.

Conveniently, the thermoelectric element collects both low grade energy and high grade energy. In this regard, different lighting systems generate different intensities of heat energy. The thermoelectric element is hence configured to tolerate different types of heat energy for recovery so that the energy savings can be optimally comprehensive and efficient.

Conveniently, the heat exchanger comprises a fluid filled manifold for supplying fluid to a plurality of thermoelectric elements which are positioned adjacent said light source.

Fluid from the heat exchanger can be used directly or indirectly for various purposes making the energy saving more efficient and the use of recovered energy more versatile. For example, warm or hot water can be provided directly from the heat exchanger.

Conveniently, the apparatus further comprises a flexible heat sink.

Conveniently, the apparatus further comprises a fan for directing an air flow past said light source into a designated space.

The air flow can be controlled so that said space can be heated, ventilated or humidified depending on the requirements of the user.

Conveniently, the light source is a light bulb.

Illustrative embodiments of the present invention will now be described with reference to the accompanying drawings, in which:
Figure 1 shows a schematic view of a first embodiment of the present invention;
Figure 2 shows a schematic view of a second embodiment of the present invention;
Figure 3 shows a schematic view of a third embodiment of the present invention;
Figure 4 shows a schematic view of a fourth embodiment of the present invention;
Figure 5 shows a schematic view of a fifth embodiment of the present invention; and
Figure 6 shows a schematic view of a sixth embodiment of the present invention.

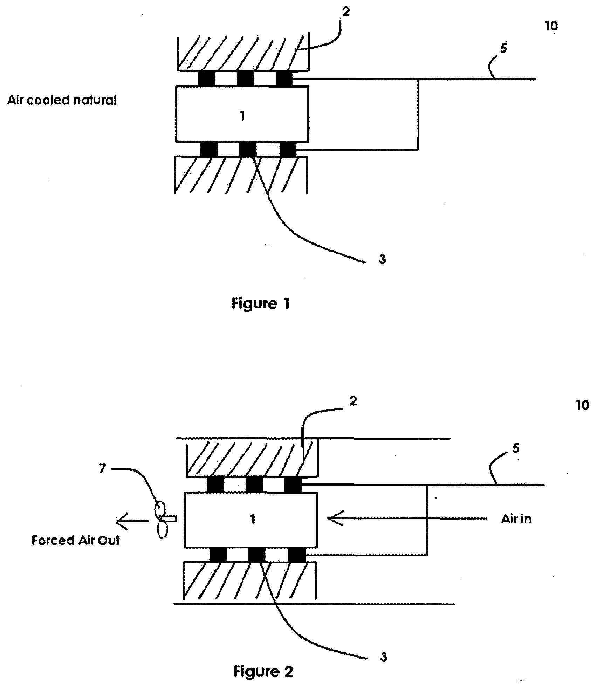

Figures 1 to 6 show a light system 10 comprising a light source 1, and at least one energy collector 3 which is disposed in close proximity at or adjacent the light source 1.

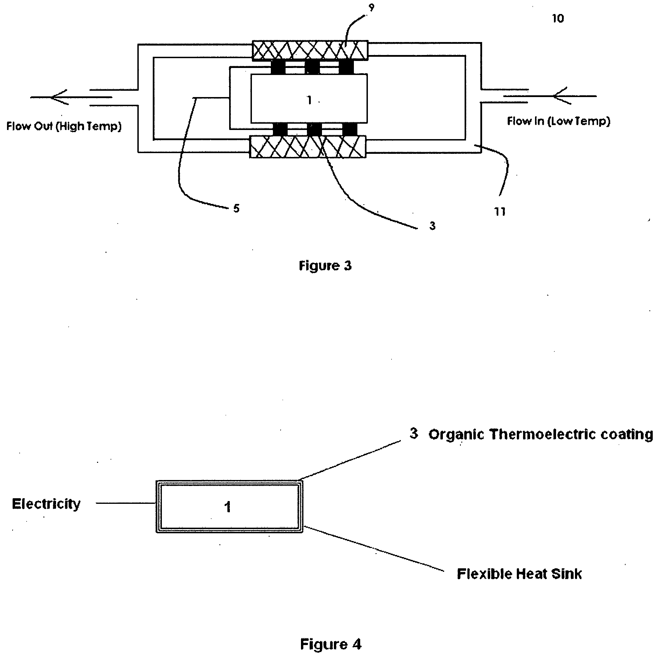

In the embodiments of Figures 1 and 2, the light source 1 may be relatively efficient lighting, such as LED lighting, which generates low grade heat. Figure 3 relates to less efficient lighting such as used in street or stadium lighting.

The energy collector 3 may comprise a thermoelectric element. The thermoelectric element can be made of thin or thick film elements depending on situation. Furthermore, as shown in Figure 4 the thermoelectric element may also be made of organic materials.

Figures 1 and 2 further show the energy collector 3 as at least partially surrounding the light source 1. The energy collector 3 is thus disposed centrally between the light source 1 and heat sinks 2.

As there is a temperature difference between surface of the light source 1 and the heat sink 2, the energy collector (thermoelectric element) 3 is able to recover wasted low grade heat and convert this to electrical energy. The energy collector 3 (thermoelectric element) is connected to an electrical circuit 5 (partially shown) so that the wasted energy can be collected, stored or used if necessary.

As shown in Figure 2, a fan 7 sets up an air flow in channels provided between the light source 1 and the energy collector 3. This air can be directed into or from a space to provide a heating or cooling effect on the space as required.

Figure 3 illustrates a light system 10 which has a light source 1 which generates high grade heat. Such light source may be found in sports lighting, street lighting and industrial lighting systems. Once again, at least one energy collector 3 is provided in close proximity of the light source 1. The energy collector 3 at least partially surrounds the light source 1 so that the wasted heat energy can be efficiently recovered.

In the embodiment of Figure 3, the apparatus further comprises a heat exchanger having heat exchanger elements 9. The heat exchanger is positioned outwardly of the thermoelectric element 3, so that the energy collector elements 3 are disposed between the light source 1 and the heat exchanger elements 9.

The heat exchanger is connected to a passage 11 in which a fluid flows in from a predetermined direction (as indicated by the arrow). The fluid flows in at a relatively low temperature. In passing through the heat exchanger elements 9, some of the excess heat energy wasted by the lighting system 10 is passed to the fluid. This can then be harvested from the fluid as appropriate.

The wasted heat energy is also collected by the thermoelectric elements 3 which can generate electricity (power).

Figure 4 shows a light source 1 with an organic thermoelectric element which is formed by coating a flexible substrate with a patterned contact material and printing a thermoelectric material on top of the patterned contact material. In this way, p- and n- type legs are formed. Gaps between the TE legs are further filled up with a dielectric substance and a respective counter contact is coated on top. An encapsulation layer can be further coated onto the flat surface. This formation allows a flexible thin heat sink to be used to dissipate heat. The flexible thin heat sink may be made of polymer.

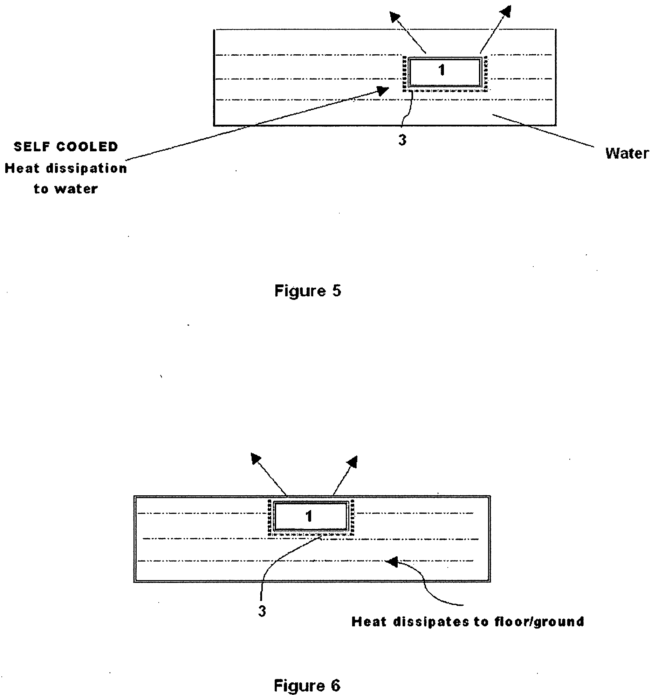

Figure 5 shows an example of the apparatus wherein the light source is immersed in water. For example, the above-described apparatus can be used as fountain lights. The energy collector 3 can generate electricity from the temperature difference between water and the light source. In this case, the heat dissipates within water which results in self-cooling of the apparatus.

Figure 6 shows an example of the above-described apparatus being used in the floor/ground. In such a case, as the heat dissipates to the floor/ground, the energy collector generates electricity from the difference in the temperature of the floor/ground and the light source.

The light system 10 illustrated in Figures may be installed in a building where the energy collector 3 may supply required energy to drive HVAC systems within the building or the lighting system 10 may be incorporated as a part of the HVAC systems. By incorporating the lighting system 10 it is possible to generate power, to provide heating/cooling or provide water. Furthermore, dehumidifying of a given space is also possible. Taken in the industrial situation, such light systems can provide means to power desalination or to support desiccant processes by recovering the otherwise wasted heat energy.

It will be understood that the described embodiments relate to preferred examples of the invention and that the present invention encompasses variants that fall within the scope of the appended claims.

## Claims

1. Apparatus for collecting energy within a powered lighting system (10), said apparatus comprising:-
a light source (1);
a heat exchanger;
**characterised in that** the apparatus further comprises a thermoelectric element (3) disposed between the light source (1) and the heat exchanger, and being at or adjacent to the light source (1) for recovering heat energy produced by the light source (1) to generate electricity; and
air flow channels provided between the light source (1) and the thermoelectric element (3) for guiding air flow around the light source (1) for recovering heat energy produced by the light source (1).

2. Apparatus according to claim 1, wherein the thermoelectric element (3) is a thin film element.

3. Apparatus according to claim 1, wherein the thermoelectric element (3) is a thick film element.

4. Apparatus according to claim 1, wherein the thermoelectric element (3) is an organic element.

5. Apparatus according to claims 2 to 5, wherein the thermoelectric element (3) collects both low grade energy and high grade energy.

6. Apparatus according to any preceding claim, wherein the heat exchanger comprises a fluid filled manifold for supplying fluid to a plurality of thermoelectric elements (3) which are positioned adjacent said light source (1).

7. Apparatus according to any preceding claim, further comprising a flexible heat sink (2).

8. Apparatus according to any preceding claim, further comprising a fan (7) for directing air flow through the air flow channels past the light source (1) into a designated space.

9. Apparatus according to any preceding claim, the light source (1) is a light bulb.

## Patentansprüche

1. Eine Vorrichtung für die Gewinnung von Energie aus einer angetriebenen Beleuchtungsanlage (10), die besagte Vorrichtung weist dabei Folgendes auf:-
eine Lichtquelle (1);
einen Wärmetauscher;
**dadurch gekennzeichnet, dass** die Vorrichtung darüberhinaus ein thermoelektrisches Element (3) aufweist, das zwischen der Lichtquelle (1) und dem Wärmetauscher angebracht ist, und sich an der oder neben der Lichtquelle (1) für die Rückgewinnung von Wärmeenergie, die von der Lichtquelle (1) produziert wird, befindet, um Elektrizität zu erzeugen; und
Luftführungskanäle, die zwischen der Lichtquelle (1) und dem thermoelektrischen Element (3) angebracht sind, um einen Luftstrom um die Lichtquelle (1) für die Rückgewinnung von Wärmeenergie zu leiten, die durch die Lichtquelle (1) produziert wird.

2. Die Vorrichtung gemäß Anspruch 1, wobei das thermoelektrische Element (3) ein dünnes Folienelement ist.

3. Die Vorrichtung gemäß Anspruch 1, wobei das thermoelektrische Element (3) ein dickes Folienelement ist.

4. Die Vorrichtung gemäß Anspruch 1, wobei das thermoelektrische Element (3) ein organisches Element ist.

5. Die Vorrichtung gemäß eines der Ansprüche 2 bis 5, wobei das thermoelektrische Element (3) sowohl niederqualitative Energie als auch hochwertige Energie gewinnt.

6. Die Vorrichtung gemäß eines der vorhergehenden Ansprüche, wobei der Wärmetauscher einen fluidgefüllten Verteiler für die Lieferung eines Fluids an eine Vielzahl von thermoelektrischen Elementen (3) aufweist, die neben der besagten Lichtquelle (1) positioniert sind.

7. Die Vorrichtung gemäß eines der vorhergehenden Ansprüche, die darüberhinaus einen flexiblen Wärmeableiter (2) aufweist.

8. Die Vorrichtung gemäß eines der vorhergehenden Ansprüche, die darüberhinaus ein Gebläse (7) aufweist, um den Luftstrom durch die Luftführungskanäle an der Lichtquelle (1) vorbei zu einer bestimmten Stelle zu leiten.

9. Die Vorrichtung gemäß eines der vorhergehenden Ansprüche, wobei die Lichtquelle (1) eine Glühbirne ist.

## Revendications

1. Un appareil destiné à la collecte de l'énergie à l'intérieur d'un système d'éclairage alimenté (10), ledit appareil comprenant :
une source lumineuse (1) ;
un échangeur de chaleur;
**caractérisé en ce que** l'appareil comprend en outre un élément thermoélectrique (3) disposé entre la source lumineuse (1) et l'échangeur de chaleur et étant adjacent à la source lumineuse (1) ou adjacent à celle-ci et destiné à la récupération de l'énergie thermique produite par la source lumineuse (1) pour générer de l'électricité; et
des canaux d'écoulement d'air fournis entre la source lumineuse (1) et l'élément thermoélectrique (3) servant au guidage de l'écoulement d'air autour de la source lumineuse (1) destinés à la récupération de l'énergie thermique produite par la source lumineuse (1).

2. Un appareil selon la revendication 1, dans laquelle l'élément thermoélectrique (3) est un élément de film mince.

3. Un appareil selon la revendication 1, dans laquelle l'élément thermoélectrique (3) est un élément de film épais.

4. Un appareil selon la revendication 1, dans laquelle l'élément thermoélectrique (3) est un élément organique.

5. Un appareil selon les revendications 2 à 5, dans lesquelles l'élément thermoélectrique (3) collecte à la fois l'énergie à faible teneur et l'énergie à teneur élevée.

6. Un appareil selon une quelconque revendication précédente, dans laquelle l'échangeur thermique comprend un collecteur rempli de fluide destiné à la fourniture de fluide à une pluralité d'éléments thermoélectriques (3) qui sont positionnés adjacents à ladite source lumineuse (1).

7. Un appareil selon une quelconque revendication précédente, comprenant en outre un puits de chaleur flexible (2).

8. Un appareil selon une quelconque revendication précédente, comprenant en outre un ventilateur (7) destiné à diriger l'écoulement d'air à travers les canaux d'écoulement d'air au-delà de la source lumineuse (1) dans un espace désigné.

9. Un appareil selon une quelconque revendication précédente, la source lumineuse (1) est une ampoule.
